# EUROPEAN PATENT APPLICATION

(11) **EP 4 835 565 A1**
(43) Date of publication of application: **04.11.2026**
(21) Application number: 24912739.0
(22) Date of filing: 23.12.2024
(51) Int. Cl.: G03F 1/24

(54) **SUBSTRATE WITH MULTILAYER REFLECTIVE FILM, REFLECTIVE MASK BLANK, REFLECTIVE MASK, AND METHOD FOR MANUFACTURING SEMICONDUCTOR DEVICE**

(30) Priority: 28.12.2023 JP 2023222968
(71) Applicant: HOYA CORPORATION, Shinjuku-ku Tokyo 160-8347 (JP)
(72) Inventor: KISHIDA, Hibiki, Tokyo 160-8347 (JP)
(74) Representative: Vossius & Partner Patentanwälte Rechtsanwälte mbB
(86) International application number: PCT/JP2024/045495
(87) International publication number: WO 2025/142852

(57) **Abstract**

Provided is a substrate with a multilayer reflective film, comprising a protective film comprising a first layer and a second layer, in which the substrate with a multilayer reflective film maintains reflectance for EUV light even under a high temperature heat treatment by suppressing thermal diffusion of the protective film.

The substrate with a multilayer reflective film comprises the protective film comprising the first layer on a multilayer reflective film and the second layer in contact with the first layer. The first layer and the second layer of the protective film comprise silicon (Si), and a P value of the protective film is 1.5 or more and 10.0 or less. The P value is calculated based on a Si2p spectrum analyzed by X-ray photoelectron spectroscopy, and is defined as: P= (S_{SiX}/S_{Si}) × (u_{SiX} - u_{Si}), in which SiX: compound of Si, S_{Si}: area of peak derived from Si in Si2p spectrum, S_{SiX}: area of peak derived from SiX in Si2p spectrum, u_{Si}: position of peak derived from Si, and u_{SiX}: position of peak derived from SiX.

## Description

### Technical Field

The present invention relates to a reflective mask used for manufacturing a semiconductor device and the like, and a substrate with a multilayer reflective film and a reflective mask blank used for manufacturing the reflective mask. The present invention also relates to a method for manufacturing a semiconductor device using the above reflective mask.

### Background Art

With a further demand for higher density and higher accuracy of a VLSI device in recent years, extreme ultraviolet (hereinafter, referred to as "EUV") lithography, which is an exposure technique using EUV light, has been proposed.

A reflective mask includes a multilayer reflective film for reflecting exposure light formed on a substrate, and an absorber pattern which is a patterned absorber film formed on the multilayer reflective film for absorbing exposure light. In EUV lithography using the reflective mask, a light image reflected by the multilayer reflective film of the reflective mask is transferred onto a semiconductor substrate (transferred object) such as a silicon wafer through a reflective optical system.

For example, Patent Document 1 describes a reflective mask blank for manufacturing a reflective mask. Specifically, Patent Document 1 describes a reflective mask blank including a substrate, a multilayer reflective film that is formed on the substrate and reflects exposure light, a protective film that is formed on the multilayer reflective film and protects the multilayer reflective film, and an absorber film that is formed on the protective film and absorbs exposure light. Patent Document 1 describes that the protective film of the reflective mask blank is made of a ruthenium compound containing ruthenium (Ru) and at least one selected from molybdenum (Mo), niobium (Nb), zirconium (Zr), yttrium (Y), boron (B), titanium (Ti), and lanthanum (La).

The above-described EUV lithography is an exposure technique using extreme ultraviolet light (EUV light). The EUV light refers to light in a wavelength band of a soft X-ray region or a vacuum ultraviolet region, and is specifically light having a wavelength of about 0.2 to 100 nm. In a case of the EUV lithography, EUV light having a wavelength of 13 to 14 nm (for example, a wavelength of 13.5 nm) can be used.

In the EUV lithography, a reflective mask having an absorber pattern is used. EUV light with which the reflective mask is irradiated is absorbed in a portion where the absorber pattern is present, and is reflected in a portion where the absorber pattern is not present. A multilayer reflective film is exposed in the portion where the absorber pattern is not present. The multilayer reflective film exposed on a surface of the reflective mask reflects the EUV light. In the EUV lithography, a light image reflected by the multilayer reflective film (a portion where the absorber pattern is not present) is transferred onto a semiconductor substrate (transferred object) such as a silicon wafer through a reflective optical system.

As the multilayer reflective film, a multilayer film in which elements having different refractive indices are periodically layered is used. For example, as a multilayer reflective film for EUV light having a wavelength of 13 to 14 nm (for example, a wavelength of 13.5 nm), a Mo/Si periodic layered film in which a Mo film having a low refractive index and a Si film having a high refractive index are alternately layered for 40 to 60 periods is used.

In order to achieve high density and high accuracy of a semiconductor device using the reflective mask, a reflection region (surface of a multilayer reflective film) in the reflective mask needs to have a high reflectance for EUV light that is exposure light.

In a process of manufacturing the reflective mask, when an absorber pattern is formed, an absorber film is processed by etching via a resist pattern or an etching mask pattern. In order to process the absorber film into a designed shape, it is necessary to slightly perform over-etching on the absorber film. At the time of over-etching, a multilayer reflective film under the absorber film is also damaged by etching. In order to prevent the multilayer reflective film from being damaged by etching, a protective film is disposed between the absorber film and the multilayer reflective film. Therefore, the protective film needs to have high resistance to an etching gas used for etching the absorber film.

As a material of the protective film having high resistance to the etching gas of the absorber film, for example, a metal such as Ru or RuNb is used. Meanwhile, when an outermost surface of the multilayer reflective film is a low refractive index layer such as a Mo film, the low refractive index layer is easily oxidized. A reflectance of the reflective mask may decrease due to oxidation of the low refractive index layer. In order to prevent oxidation of the low refractive index layer, a silicon-containing layer such as a Si film can be disposed on the outermost surface of the multilayer reflective film. Note that since the silicon-containing layer is a thin film for protecting the multilayer reflective film from oxidation, the silicon-containing layer is treated as a part of the protective film in the present specification. In the present specification, a thin film included in the protective film for protecting the multilayer reflective film from oxidation, such as a silicon-containing layer, is referred to as a "first layer". In addition, in the above-described protective film, a thin film having high resistance to an etching gas used for etching the absorber film is referred to as a "second layer". Generally, the first layer is disposed on the multilayer reflective film, and the second layer is disposed on the first layer.

When the protective film of the substrate with a multilayer reflective film has a structure in which the second layer containing a metal material is disposed on the first layer (for example, a Si thin film) on the multilayer reflective film, a heat treatment may be performed on the substrate with a multilayer reflective film or the like in a reflective mask manufacturing process. The heat treatment for the substrate with a multilayer reflective film or a reflective mask blank may be generally performed for stress adjustment of the substrate with a multilayer reflective film or the reflective mask blank.

As described above, when the protective film has a structure in which the second layer is disposed on the first layer containing, for example, silicon (Si) or the like, a phenomenon may occur in which a reflectance of the substrate with a multilayer reflective film for EUV light decreases due to a heat treatment or the like in the reflective mask manufacturing process. A reason for this is considered to be that silicon in the first layer diffuses into the second layer. In order to prevent a decrease in reflectance of the substrate with a multilayer reflective film, it is necessary to prevent silicon in the first layer from diffusing into the second layer. In order to prevent silicon in the first layer from diffusing into the second layer, it is conceivable to nitride and/or oxidize a surface of the first layer (an interface between the first layer and the second layer).

For example, Patent Document 2 discloses a substrate with a reflective film for EUV lithography, in which a Ru protective layer containing silicon and oxygen is formed on an outermost surface of a multilayer reflective film containing silicon in order to suppress a decrease in reflectance for EUV light due to oxidation of the Ru protective film. In addition, Patent Documents 3 and 4 disclose a substrate with a reflective film in which a Ru protective layer containing silicon and nitrogen is formed on an outermost surface of a multilayer reflective film containing silicon.

### Prior Art Documents

### Patent Documents

Patent Document 1: JP 2005-268750 A
Patent Document 2: WO 2011/068223 A
Patent Document 3: WO 2011/071123 A
Patent Document 4: WO 2023/074770 A

### Summary of Invention

### Technical Problem

As described above, there is a problem that a reflectance for EUV exposure light is decreased by mutual diffusion of silicon (Si) between the first layer and the second layer on the multilayer reflective film due to a heat treatment or the like when a reflective mask is manufactured from a reflective mask blank. In particular, in recent years, a metal oxide film resist that has been studied for high NA (numerical aperture) exposure needs to be baked at a higher temperature than a currently used temperature, and an output of a light source has been increased with improvement of EUV exposure accuracy. Therefore, a reflective mask that can withstand a higher temperature than a conventional one, a reflective mask blank for manufacturing the reflective mask, and the like are required.

It can be said that the mutual diffusion of Si in the protective film when a thermal load is applied depends on a chemical bonding state between Si and another component (X) at an interface between the first layer and the second layer. The present inventor has paid attention to a fact that an effect of suppressing thermal diffusion in the protective film increases as a chemical shift of a Si2p spectrum measured by X-ray photoelectron spectroscopy (XPS) increases, and has newly defined a P value calculated based on the Si2p spectrum as an index of suppressing thermal diffusion.

An object of the present invention is to provide a substrate with a multilayer reflective film, including a multilayer reflective film and a protective film including a first layer and a second layer each containing Si on the multilayer reflective film, in which a P value calculated based on a Si2p spectrum of the protective film is set in a range of a predetermined value or more, thereby suppressing thermal diffusion and maintaining a reflectance for EUV light even under a high temperature heat treatment. Another object of the present invention is to obtain a substrate with a multilayer reflective film having high heat resistance, in which a P value calculated based on a Si2p spectrum of the protective film is set in a range of a predetermined value or more, thereby maintaining a reflectance for EUV light even under a high temperature heat treatment.

Still another object of the present invention is to obtain a reflective mask blank or a reflective mask having high heat resistance, in which a P value calculated based on a Si2p spectrum of the protective film is set in a range of a predetermined value or more, thereby maintaining a reflectance for EUV light even under a high temperature heat treatment.

### Solution to Problem

In order to solve the above problems, the present invention has the following configurations.

(Configuration 1)

Configuration 1 is a substrate with a multilayer reflective film, comprising: a substrate; a multilayer reflective film disposed on the substrate; and a protective film disposed on the multilayer reflective film, wherein
the protective film comprises a first layer on the multilayer reflective film and a second layer in contact with the first layer,
the first layer and the second layer of the protective film comprise silicon (Si),
a P value of the protective film is 1.5 or more and 10.0 or less, and
the P value is calculated based on a Si2p spectrum analyzed by X-ray photoelectron spectroscopy, and is defined as: $P = \left({S}_{SiX}/{S}_{Si}\right) \times \left({u}_{SiX}-{u}_{Si}\right) ,$ wherein
SiX: compound of Si;
S_{Si}: area of peak derived from Si in Si2p spectrum;
S_{SiX}: area of peak derived from SiX in Si2p spectrum;
u_{Si}: position of peak derived from Si; and
u_{SiX}: position of peak derived from SiX.

### (Configuration 2)

Configuration 2 is the substrate with a multilayer reflective film according to configuration 1, wherein the first layer comprises silicon (Si) and one or more elements selected from oxygen (O) and nitrogen (N).

### (Configuration 3)

Configuration 3 is the substrate with a multilayer reflective film according to configuration 2, wherein a ratio of a content of one or more elements selected from O and N to a content of Si in the first layer is 0.1 or more and 1.5 or less.

### (Configuration 4)

Configuration 4 is the substrate with a multilayer reflective film according to configuration 1, wherein the second layer comprises one or more elements selected from ruthenium (Ru), rhodium (Rh), and iridium (Ir).

### (Configuration 5)

Configuration 5 is the substrate with a multilayer reflective film according to any one of configurations 1 to 4, wherein the second layer comprises one or more elements selected from thallium (Tl), hafnium (Hf), titanium (Ti), zirconium (Zr), yttrium (Y), manganese (Mn), indium (In), gallium (Ga), cadmium (Cd), bismuth (Bi), tantalum (Ta), lead (Pb), silver (Ag), aluminum (Al), vanadium (V), niobium (Nb), tin (Sn), zinc (Zn), mercury (Hg), chromium (Cr), iron (Fe), antimony (Sb), tungsten (W), molybdenum (Mo), and copper (Cu).

### (Configuration 6)

Configuration 6 is a reflective mask blank comprising an absorber film on the protective film of the substrate with a multilayer reflective film according to any one of configurations 1 to 5.

### (Configuration 7)

Configuration 7 is a reflective mask comprising an absorber pattern obtained by patterning the absorber film of the reflective mask blank according to configuration 6.

### (Configuration 8)

Configuration 8 is a method for manufacturing a semiconductor device, comprising performing a lithography process with an exposure apparatus using the reflective mask according to configuration 7 to form a transfer pattern on a transferred object.

### Advantageous Effects of Invention

According to the present invention, in a substrate with a multilayer reflective film, including a multilayer reflective film, and a first layer and a second layer containing Si on the multilayer reflective film, it is possible to maintain a reflectance for EUV light even under a high temperature heat treatment and to have high heat resistance. In addition, the present invention can obtain a substrate with a multilayer reflective film maintaining a reflectance for EUV light even under a high temperature heat treatment and having high heat resistance.

In addition, the present invention can obtain a reflective mask blank or a reflective mask maintaining a reflectance for EUV light even under a high temperature heat treatment and having high heat resistance.

### Brief Description of Drawings

Fig. 1 is a schematic cross-sectional view illustrating an example of a substrate with a multilayer reflective film of the present embodiment.
Fig. 2 is a schematic cross-sectional view illustrating an example of a reflective mask blank of the present embodiment.
Fig. 3 is a schematic cross-sectional view illustrating another example of the reflective mask blank of the present embodiment.
Fig. 4 is a diagram for explaining a method for calculating a P value based on a Si2p spectrum measured in a protective film.
Fig. 5 is a diagram for explaining a method for determining a measurement depth of the Si2p spectrum in the protective film.
Fig. 6A is a schematic cross-sectional view illustrating an example of a method for manufacturing a reflective mask of the present embodiment.
Fig. 6B is a schematic cross-sectional view further illustrating the example of the method for manufacturing a reflective mask of the present embodiment.
Fig. 6C is a schematic cross-sectional view further illustrating the example of the method for manufacturing a reflective mask of the present embodiment.
Fig. 6D is a schematic cross-sectional view further illustrating the example of the method for manufacturing a reflective mask of the present embodiment.
Fig. 7 is a schematic diagram illustrating an example of an EUV exposure apparatus.

### Description of Embodiments

Hereinafter, an embodiment of the present invention will be specifically described with reference to the drawings. Note that the following embodiment is a mode for specifically describing the present invention and does not limit the present invention within the scope thereof.

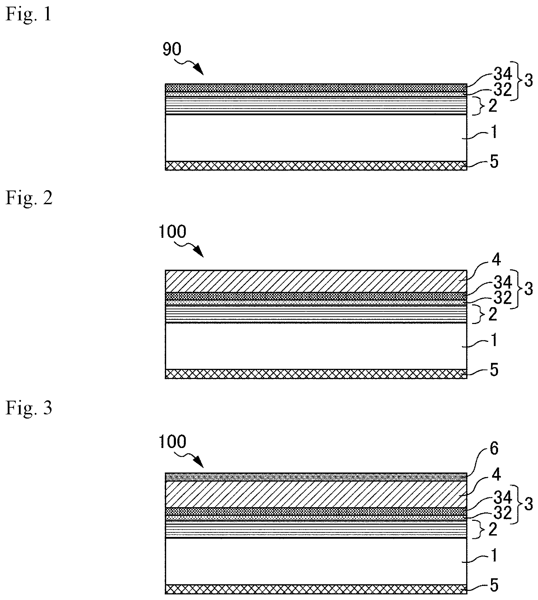

Fig. 1 is a schematic cross-sectional view illustrating an example of a substrate 90 with a multilayer reflective film of the present embodiment. The substrate 90 with a multilayer reflective film illustrated in Fig. 1 includes a multilayer reflective film 2 and a protective film 3 on a substrate 1. The protective film 3 includes a first layer 32 and a second layer 34 in this order on the multilayer reflective film 2. Note that the substrate 90 with a multilayer reflective film can further include another thin film such as a conductive back film 5.

Fig. 2 is a schematic cross-sectional view illustrating an example of a reflective mask blank 100 of the present embodiment. The reflective mask blank 100 illustrated in Fig. 2 includes the multilayer reflective film 2, the protective film 3, and an absorber film 4 on the substrate 1. The reflective mask blank 100 can include the conductive back film 5. Note that the substrate 90 with a multilayer reflective film can further include another thin film such as a resist film 11.

Fig. 3 is a schematic cross-sectional view illustrating another example of the reflective mask blank 100. The reflective mask blank 100 illustrated in Fig. 3 further includes an etching mask film 6 on the absorber film 4 in addition to the configuration illustrated in Fig. 2. Note that the reflective mask blank 100 can further include another thin film such as the resist film 11.

In the present specification, "a thin film B is disposed (formed) on a thin film A (or substrate)" includes not only a case where the thin film B is disposed (formed) in contact with a surface of the thin film A (or substrate) but also a case where there is another thin film C between the thin film A (or substrate) and the thin film B. In addition, in the present specification, for example, "a thin film B is disposed in contact with a surface of a thin film A (or substrate)" means that the thin film A (or substrate) and the thin film B are disposed in direct contact with each other without another thin film interposed between the thin film A (or substrate) and the thin film B. In addition, in the present specification, "on" does not necessarily mean an upper side in the vertical direction. "On" merely indicates a relative positional relationship among a thin film, a substrate, and the like.

### <Substrate 90 with a multilayer reflective film>

The present embodiment is the substrate 90 with a multilayer reflective film, including the substrate 1, the multilayer reflective film 2 disposed on the substrate 1, and the protective film 3 disposed on the multilayer reflective film 2. The substrate 90 with a multilayer reflective film of the present embodiment will be specifically described.

### <<Substrate 1>>

As the substrate 1, a substrate having a low thermal expansion coefficient within a range of 0 ± 5 ppb/°C is preferably used in order to prevent distortion of a transfer pattern due to heat during exposure to EUV light. As a material having a low thermal expansion coefficient within this range, for example, SiO₂-TiO₂-based glass or multicomponent-based glass ceramic can be used.

A main surface (first main surface) of the substrate 1 on a side where a transfer pattern (absorber pattern 4a described later) is formed is preferably processed in order to increase a flatness. By increasing the flatness of the main surface of the substrate 1, position accuracy and transfer accuracy of the pattern can be increased. For example, in a case of EUV exposure, the flatness in a region of 132 mm × 132 mm of the main surface of the substrate 1 on the side where the transfer pattern is formed is preferably 0.1 µm or less, more preferably 0.05 µm or less, and particularly preferably 0.03 µm or less. In addition, a second main surface (back surface) opposite to the side where the transfer pattern is formed is a surface to be fixed to an exposure apparatus by electrostatic chuck. A flatness in a region of 142 mm × 142 mm of the back surface is preferably 0.1 µm or less, more preferably 0.05 µm or less, and particularly preferably 0.03 µm or less. Note that, in the present specification, the flatness is a value representing warpage (deformation amount) of a surface indicated by total indicated reading (TIR). The flatness (TIR) is an absolute value of a difference in height between the highest position of a surface of the substrate 1 above a focal plane and the lowest position of the surface of the substrate 1 below the focal plane, in which the focal plane is a plane defined by a least squares method using the surface of the substrate 1 as a reference.

In a case of EUV exposure, the main surface of the substrate 1 on a side where the transfer pattern is formed preferably has a surface roughness of 0.1 nm or less in terms of root mean square roughness (Rq). Note that the surface roughness can be measured with an atomic force microscope.

The substrate 1 preferably has a high rigidity in order to prevent deformation due to a film stress of a thin film (such as the multilayer reflective film 2) formed on the substrate 1. In particular, the substrate 1 preferably has a high Young's modulus of 65 GPa or more.

### <<Multilayer reflective film 2>>

The substrate 90 with a multilayer reflective film of the embodiment includes the multilayer reflective film 2. The multilayer reflective film 2 imparts a function of reflecting EUV light in the reflective mask 200. The multilayer reflective film 2 is a multilayer film in which layers mainly containing elements having different refractive indices are periodically layered.

In general, as the multilayer reflective film 2, a multilayer film in which a thin film (high refractive index layer) of a light element that is a high refractive index material or a compound of the light element and a thin film (low refractive index layer) of a heavy element that is a low refractive index material or a compound of the heavy element are alternately layered for about 40 to 60 periods is used.

When a stack of high refractive index layer/low refractive index layer in which the high refractive index layer and the low refractive index layer are layered in this order from the substrate 1 side is counted as one period, the multilayer film used as the multilayer reflective film 2 can be formed by building up the stack for a plurality of periods. In addition, when a stack of low refractive index layer/high refractive index layer in which the low refractive index layer and the high refractive index layer are layered in this order from the substrate 1 side is counted as one period, the multilayer film can be formed by building up the stack for a plurality of periods. Note that an outermost layer of the multilayer reflective film 2, that is, a surface layer of the multilayer reflective film 2 opposite to the substrate 1 side is preferably the high refractive index layer. In the above-described multilayer film, when a stack of high refractive index layer/low refractive index layer in which the high refractive index layer and the low refractive index layer are layered in this order from the substrate 1 side is counted as one period and the stack is built up for a plurality of periods, the uppermost layer is the low refractive index layer. In this case, when the low refractive index layer constitutes an outermost surface of the multilayer reflective film 2, the low refractive index layer is easily oxidized and a reflectance of the reflective mask 200 is therefore reduced. Therefore, the high refractive index layer is preferably further formed on the uppermost low refractive index layer. Note that the high refractive index layer formed on the uppermost low refractive index layer can be the first layer 32 of the protective film 3 described later. Meanwhile, in the above-described multilayer film, when a stack of low refractive index layer/high refractive index layer in which the low refractive index layer and the high refractive index layer are layered in this order from the substrate 1 side is counted as one period and the stack is built up for a plurality of periods, the uppermost layer is the high refractive index layer. Therefore, in this case, it is not necessary to further form the high refractive index layer. Note that the uppermost high refractive index layer in this case can also serve as the first layer 32 of the protective film 3 described later.

As the high refractive index layer, a layer containing silicon (Si) can be used. As a material containing Si, a Si compound containing Si and boron (B), carbon (C), nitrogen (N), oxygen (O), and/or hydrogen (H) can be used in addition to a Si simple substance. By using the high refractive index layer containing Si, the reflective mask 200 having an excellent reflectance for EUV light can be obtained. In addition, as the low refractive index layer, a metal simple substance selected from molybdenum (Mo), ruthenium (Ru), rhodium (Rh), and platinum (Pt), or an alloy thereof can be used. In addition, to these metal simple substances or alloys, boron (B), carbon (C), nitrogen (N), oxygen (O), and/or hydrogen (H) may be added. In the substrate 90 with a multilayer reflective film of the present embodiment, the low refractive index layer is preferably a molybdenum (Mo) layer, and the high refractive index layer is preferably a silicon (Si) layer. For example, as the multilayer reflective film 2 for reflecting EUV light having a wavelength of 13 nm to 14 nm (for example, a wavelength of 13.5 nm), a Mo/Si periodic layered film in which a Mo layer and a Si layer are alternately layered for about 40 to 60 periods can be preferably used. In the substrate 90 with a multilayer reflective film of the present embodiment, the low refractive index layer is preferably a ruthenium (Ru) layer, and the high refractive index layer is preferably a silicon (Si) layer. For example, as the multilayer reflective film 2 for reflecting EUV light having a wavelength of 13 nm to 14 nm (for example, a wavelength of 13.5 nm), a Ru/Si periodic layered film in which a Ru layer and a Si layer are alternately layered for about 30 to 40 periods can be preferably used.

A reflectance of the multilayer reflective film 2 alone is usually 65% or more, and an upper limit thereof is usually 73%. Note that the film thickness and period of each constituent layer of the multilayer reflective film 2 can be appropriately selected depending on an exposure wavelength. Specifically, the film thickness and period of each constituent layer of the multilayer reflective film 2 can be selected so as to satisfy Bragg's reflection law. In the multilayer reflective film 2, there are a plurality of high refractive index layers and a plurality of low refractive index layers, but the film thickness does not need to be the same between the high refractive index layers and between the low refractive index layers.

A method for forming the multilayer reflective film 2 is publicly known in this technical field. For example, the multilayer reflective film 2 can be formed by forming each layer by an ion beam sputtering method. In the case of the above-described Mo/Si periodic multilayer film, a Si film having a thickness of about 4 nm is first formed on the substrate 1 using a Si target, for example, by an ion beam sputtering method. Then, a Mo film having a thickness of about 3 nm is formed using a Mo target. This stack is counted as one period, and the stack is built up for 40 to 60 periods to form the multilayer reflective film 2 (the uppermost layer is a Si film). Note that, in a case of 60 periods, the number of steps is larger than the number of steps in a case of 40 periods, but a reflectance for EUV light can be increased.

### <<Protective film 3>>

As illustrated in Fig. 1, the substrate 90 with a multilayer reflective film of the present embodiment includes the predetermined protective film 3 on the multilayer reflective film 2. When the reflective mask 200 is manufactured, the absorber film 4 is etched to be processed into the absorber pattern 4a. Since the protective film 3 has high etching resistance, damage to a surface of the multilayer reflective film 2 can be suppressed when the absorber film 4 is etched. Therefore, by inclusion of the protective film 3 on the multilayer reflective film 2, damage to a surface of the multilayer reflective film 2 can be suppressed when the reflective mask 200 is manufactured using the substrate 90 with a multilayer reflective film. Therefore, a reflectance characteristic of the obtained reflective mask 200 for EUV light is favorable.

In the present specification, the predetermined protective film 3 that can be used for the substrate 90 with a multilayer reflective film of the present embodiment may be referred to as "protective film 3 of the present embodiment".

The protective film 3 of the present embodiment includes the first layer 32 and the second layer 34. The first layer 32 and the second layer 34 contain silicon (Si). The first layer 32 is disposed between the second layer 34 and the multilayer reflective film 2. The first layer 32 is a thin film having a function of protecting the multilayer reflective film 2 from oxidation. In the present specification, the first layer 32 is a part of the protective film 3. The first layer 32 can also serve as an uppermost layer of the multilayer reflective film 2. The second layer 34 is a thin film having a function of having high resistance to an etching gas used for etching the absorber film 4. The second layer 34 needs to be a thin film having a high reflectance for EUV light and high etching resistance to an etching gas used for etching the absorber film 4.

When the protective film 3 has a structure in which the second layer 34 is disposed on the first layer 32, a phenomenon may occur in which a reflectance of the substrate 90 with a multilayer reflective film for EUV light decreases due to a heat treatment or the like in a reflective mask manufacturing process. A reason for this is considered to be that a predetermined element (an element exhibiting a function of the first layer 32) of the first layer 32 diffuses into the second layer 34. In order to prevent a decrease in reflectance of the substrate 90 with a multilayer reflective film, it is necessary to prevent the predetermined element of the first layer 32 from diffusing into the second layer 34. In order to prevent the predetermined element of the first layer 32 from diffusing into the second layer 34, it is conceivable to nitride and/or oxidize a surface of the first layer 32 (an interface between the first layer 32 and the second layer 34). Meanwhile, it has been found that nitriding and/or oxidizing the surface of the first layer 32 (an interface with the second layer 34) causes a problem that adhesion between the first layer 32 and the second layer 34 is reduced. When the adhesion between the first layer 32 and the second layer 34 is reduced, a film peeling defect may occur.

The protective film 3 of the present embodiment contains at least one metal element Em and at least one metal element Ea. That is, the first layer 32 and the second layer 34 constituting the protective film 3 can contain the metal element Em and/or the metal element Ea. The protective film 3 of the present embodiment contains the metal element Em, whereby the protective film 3 can have high etching resistance to an etching gas for the absorber film 4. In addition, the protective film 3 of the present embodiment contains the metal element Ea, whereby adhesion between the first layer 32 and the second layer 34 can be improved. Therefore, occurrence of a film peeling defect can be suppressed by the protective film 3 of the present embodiment. That is, with the protective film 3 of the present embodiment, it is possible to obtain the substrate 90 with a multilayer reflective film capable of improving adhesion between the first layer 32 and the second layer 34 while maintaining high etching resistance of the protective film 3. In addition, as described later, the protective film 3 of the present embodiment can have high heat resistance to a high temperature heat treatment or the like by setting a P value calculated based on a Si2p spectrum analyzed by X-ray photoelectron spectroscopy (XPS) within a predetermined range.

### <<<Metal element Em>>>

The protective film 3 contains at least one metal element Em. The metal element Em is an element having a Fermi level of -4.7 eV or less. In the present specification, the content (at%) of the metal element Em is indicated by a symbol "M". In the present specification, the metal element Em is also referred to as an Em element.

The metal element Em is an element (metal element) for exhibiting a function as the protective film 3. Since the metal element Em is an element having a Fermi level of -4.7 eV or less, reactivity of the metal element Em with a chlorine (Cl)-based gas, a bromine (Br)-based gas, a fluorine (F)-based gas, and a gas containing nitrogen and/or oxygen used in a reactive sputtering method as constituent elements is low. Therefore, when the metal element Em is used as a material of the protective film 3, the material is less likely to deteriorate, and a function as the protective film 3 is less likely to deteriorate. Therefore, when the metal element Em is selected according to a material of the absorber film 4 disposed on the protective film 3 and the metal element Em is used as the material of the protective film 3, the protective film 3 having high etching resistance can be obtained.

In the present specification, a Fermi level of a certain element refers to an energy value of a Fermi level of a pure substance of a simple element when a vacuum level is taken as an origin (zero). In the present specification, a Fermi level of a metal material can be energy having a negative work function value. For example, when the metal element Em is Ru, since a work function of a pure substance of a Ru simple element (pure substance of Ru metal) is 4.7 eV, a Fermi level of Ru is -4.7 eV in the present specification. The same applies to the metal element Ea described later.

The metal element Em can be an element having a Fermi level equal to or lower than the Fermi level of Ru. It is known that Ru can be preferably used as an element constituting the protective film 3. Therefore, by using an element (metal element) having a Fermi level equal to or lower than the Fermi level of Ru (a Fermi level having a large negative value), a thin film having high etching resistance can be obtained.

Examples of the element having a Fermi level equal to or lower than the Fermi level of Ru include Ru, Tc, Os, Co, Re, Rh, Pd, Au, Ni, Ir, and Pt. As the metal element Em, at least one selected from these elements can be used.

The metal element Em contained in the protective film 3 of the present embodiment is preferably one or more elements selected from ruthenium (Ru), rhodium (Rh), and iridium (Ir). The metal element Em contained in the protective film 3 of the present embodiment can consist only of one or more elements selected from ruthenium (Ru), rhodium (Rh), and iridium (Ir). By using these elements, it is possible to more reliably obtain the protective film 3 having high etching resistance while maintaining a high reflectance.

Specifically, when the protective film 3 contains Rh or Ir as the metal element Em, the etching resistance of the protective film 3 can be improved. When the protective film 3 contains Ru as the metal element Em, optical characteristics of the protective film 3 can be appropriately adjusted.

### <<<Metal element Ea>>>

The protective film 3 contains at least one metal element Ea. The metal element Ea is an element having a Fermi level of more than -4.7 eV. In the present specification, the content (at%) of the metal element Ea is indicated by a symbol "A". In the present specification, the metal element Ea is also referred to as an Ea element.

The protective film 3 contains the metal element Ea, whereby adhesion between the first layer 32 and the second layer 34 constituting the protective film 3 can be improved. Since the metal element Ea is an element having a Fermi level of more than -4.7 eV, the metal element Ea has high reactivity with other elements. Therefore, by containing the metal element Ea, the protective film 3 can contribute to improvement of adhesion between the first layer 32 and the second layer 34.

The metal element Ea can be an element having a Fermi level equal to or higher than a Fermi level of Cu. Cu can be used as an element capable of improving adhesion between two types of thin films. Therefore, by using an element having a Fermi level equal to or higher than the Fermi level of Cu (a Fermi level having a small negative value), it is possible to contribute to improvement of adhesion between the first layer 32 and the second layer 34.

The metal element Ea contained in the protective film 3 of the present embodiment is preferably one or more elements selected from thallium (Tl), hafnium (Hf), titanium (Ti), zirconium (Zr), yttrium (Y), manganese (Mn), indium (In), gallium (Ga), cadmium (Cd), bismuth (Bi), tantalum (Ta), lead (Pb), silver (Ag), aluminum (Al), vanadium (V), niobium (Nb), tin (Sn), zinc (Zn), mercury (Hg), chromium (Cr), iron (Fe), antimony (Sb), tungsten (W), molybdenum (Mo), and copper (Cu). The metal element Ea contained in the protective film 3 of the present embodiment can consist only of one or more elements selected from Tl, Hf, Ti, Zr, Y, Mn, In, Ga, Cd, Bi, Ta, Pb, Ag, Al, V, Nb, Sn, Zn, Hg, Cr, Fe, Sb, W, Mo, and Cu. By using these elements, it is possible to more reliably contribute to improvement of adhesion between the first layer 32 and the second layer 34.

The metal element Ea contained in the protective film 3 of the present embodiment is more preferably at least one selected from Ti, Zr, Ta, Nb, and Cr. As the metal element Ea contained in the protective film 3 of the present embodiment, it is more preferable to use at least one selected from Ta, Nb, and Cr. By using these elements, adhesion between the first layer 32 and the second layer 34 can be improved, and cleaning resistance can be improved.

When nitrogen is contained in the vicinity of a surface of the first layer 32 (an interface between the first layer 32 and the second layer 34), it is more preferable to use Cr as the metal element Ea contained in the protective film 3 of the present embodiment. This is because Cr reduces an extinction coefficient by being nitrided, alleviates absorption of EUV light, and can contribute to improvement of reflectance.

When oxygen is contained in the vicinity of a surface of the first layer 32 (an interface between the first layer 32 and the second layer 34), it is preferable to use at least one selected from Hf, V, and Cr as the metal element Ea contained in the protective film 3 of the present embodiment. This is because Hf, V, and Cr reduce an extinction coefficient by being oxidized, alleviate absorption of EUV light, and can contribute to improvement of reflectance.

The metal element Em can be contained in both the first layer 32 and the second layer 34. The metal element Ea can be contained in both the first layer 32 and the second layer 34. That is, if the metal element Em or Ea can be present at an interface between the first layer 32 and the second layer 34, the metal element Em or Ea can be added at the time of forming the first layer 32, or the metal element Em or Ea can be added at the time of forming the second layer 34. In addition, the metal element Em or Ea can be added at the time of forming both the first layer 32 and the second layer 34.

### <<<First layer 32>>>

The first layer 32 of the protective film 3 of the present embodiment can be disposed on the multilayer reflective film 2 in contact with the multilayer reflective film 2. The first layer 32 is a thin film of a part of the protective film 3 for protecting the multilayer reflective film 2 from oxidation. The first layer 32 of the present embodiment contains silicon (Si) and one or more elements selected from oxygen (O) and nitrogen (N).

More specifically, examples of the material of the first layer 32 include a material containing silicon (Si) (for example, Si, SiN, SiO, SiON, SiC, SiOC, SiNC, and SiONC). The first layer 32 can be, for example, a thin film formed under a condition in which the first layer 32 consists only of silicon (Si) or a thin film formed under a condition in which the first layer 32 consists only of SiN. Note that when an uppermost layer of the multilayer reflective film 2 is a high refractive index layer, the uppermost high refractive index layer can also serve as the first layer 32 of the protective film 3. In addition, the first layer 32 can be a composition-gradient film or a layered film including a plurality of thin layers.

In the first layer 32 in the present specification, the "thin film formed under a condition in which the first layer 32 consists only of silicon (Si)" or the "thin film formed under a condition in which the first layer 32 consists only of SiN" means a thin film formed under a condition in which a thin film consisting only of silicon (Si) is formed or a thin film formed under a condition in which a thin film consisting only of SiN is formed at the time of forming the first layer 32. After formation of the first layer 32 (and the second layer 34 described later), elements other than an element constituting the first layer 32 may diffuse from the multilayer reflective film 2 and the second layer 34 in the vicinity into the first layer 32. In this case, for example, the first layer 32 which is a "thin film formed under a condition in which the first layer 32 consists only of silicon (Si)" contains elements other than silicon (Si), the elements diffusing from other layers, after the formation of the first layer 32. As described above, elements of other thin films diffuse from thin films in the vicinity of the first layer 32 into the first layer 32, whereby a thin film formed under a condition in which the first layer 32 consists only of a predetermined element generally contains elements other than the predetermined element. Therefore, the thin film formed under a condition in which the first layer 32 consists only of silicon (Si) can be a thin film containing Si. In addition, the thin film formed under a condition in which the first layer 32 consists only of SiN can be a thin film containing SiN.

The first layer 32 of the protective film 3 of the present embodiment can be formed by various known methods, for example, an ion beam sputtering method, a sputtering method, a reactive sputtering method, a vapor phase growth method (CVD), and a vacuum vapor deposition method.

When the first layer 32 is a thin film formed under a condition in which the first layer 32 consists only of silicon (Si), a film can be formed under the condition in which the first layer 32 consists only of silicon (Si) at the time of forming the first layer 32. For example, the first layer 32 can be formed by an ion beam sputtering method using a Si target.

When the first layer 32 is a thin film formed under a condition in which the first layer 32 consists only of SiN, for example, the first layer 32 can be formed by a DC magnetron sputtering method (reactive sputtering method) in a nitrogen gas atmosphere using a Si target.

The first layer 32 can be a thin film formed under a condition in which the thin film contains the metal element Ea. The first layer 32 can be a thin film containing Si and the metal element Ea. The first layer 32 can contain the metal element Ea. The first layer 32 contains the metal element Ea, whereby the metal element Ea can be present at an interface between the first layer 32 and the second layer 34. As a result, adhesion between the first layer 32 and the second layer 34 can be improved.

The first layer 32 can further contain at least one selected from nitrogen (N) and oxygen (O) in the thin film containing Si and the metal element Ea. The first layer 32 preferably contains nitrogen (N) and/or oxygen (O) in the vicinity of an interface with the second layer 34. When the content of nitrogen (N) and/or oxygen (O) in the first layer 32 is high, it is possible to suppress diffusion of an element (for example, silicon (Si)) of the first layer 32 into the second layer 34. As a result, it is possible to suppress a decrease in reflectance of the second layer 34 due to diffusion of an element of the first layer 32.

In order to introduce nitrogen (N) and/or oxygen (O) into the first layer 32 or the second layer 34, the first layer 32 or the second layer 34 can be formed by a DC magnetron sputtering method (reactive sputtering method) in a nitrogen gas and/or oxygen gas atmosphere. As a result, it is possible to suppress a decrease in reflectance of the second layer 34 due to diffusion of an element of the first layer 32.

As described above, in order to prevent diffusion of an element of the first layer 32 into the second layer 34, it is preferable to introduce nitrogen (N) and/or oxygen (O) into an interface between the first layer 32 and the second layer 34 to increase a concentration of nitrogen (N) and/or a concentration of oxygen (O) at the interface between the first layer 32 and the second layer 34. However, when the concentration of nitrogen (N) and/or the concentration of oxygen (O) at the interface between the first layer 32 and the second layer 34 is too high, the reflectance decreases and the adhesion deteriorates, and therefore it is necessary to set the concentration to a predetermined concentration.

At a depth position (Dₘ) where a P value described later is measured, a ratio (O/Si) of the content of oxygen (O) to the content of silicon (Si) in the first layer 32 is preferably 0.6 or more, and more preferably 0.8 or more. In addition, the ratio (O/Si) is preferably 1.5 or less, and more preferably 1.0 or less. A ratio (N/Si) of the content of nitrogen (N) to the content of silicon (Si) in the first layer 32 is preferably 0.1 or more, and more preferably 0.2 or more. In addition, the ratio (N/Si) is preferably 0.9 or less, and more preferably 0.7 or less. Note that since a P value described later depends on a chemical bonding state between Si and another component, the ratio (N/Si) and/or (O/Si) is not necessarily proportional to the P value.

### <<<Second layer 34>>>

The second layer 34 of the protective film 3 of the present embodiment is disposed on the first layer 32 in contact with the first layer 32. The second layer 34 can be a thin film having a function of enhancing resistance of the protective film 3 to an etching gas and resistance to cleaning as the protective film 3.

The second layer 34 contains the above-described metal element Em. The second layer 34 can be a thin film formed under a condition in which the thin film contains the metal element Em. The content of the metal element Em in the second layer 34 is larger than the content of the metal element Em in the first layer 32. This is because the second layer 34 needs to be a thin film having high etching resistance.

The second layer 34 can be a thin film formed under a condition in which the thin film contains the metal element Em and the metal element Ea. The second layer 34 can contain both the metal element Em and the metal element Ea. In the second layer 34, the content of the metal element Em can be larger than the content of the metal element Ea. The second layer 34 contains the metal element Em, whereby the second layer 34 having high etching resistance can be obtained. In addition, the second layer 34 contains the metal element Ea, whereby adhesion between the first layer 32 and the second layer 34 can be more reliably improved.

The second layer 34 can be a layered film including two or more layers. A lower layer on a side in contact with the first layer 32 can be a thin film formed under a condition in which the thin film contains the metal element Ea. The lower layer of the second layer 34 can contain the metal element Ea. The lower layer of the second layer 34 contains the above-described metal element Ea, whereby the metal element Ea can be present at an interface between the first layer 32 and the second layer 34. As a result, adhesion between the first layer 32 and the second layer 34 can be improved. The metal element Ea contained in the lower layer of the second layer 34 is more preferably at least one selected from Ti, Zr, Ta, Nb, and Cr. The lower layer of the second layer 34 preferably contains no metal element Em, and more preferably contains no Ru from a viewpoint of adhesion.

An upper layer of the second layer 34 on a side in contact with the absorber film 4 can be a thin film formed under a condition in which the thin film contains the metal element Em. The upper layer of the second layer 34 can contain the metal element Em. The upper layer of the second layer 34 contains the metal element Em, whereby the metal element Em can be present at an interface between the second layer 34 and the absorber film 4. As a result, etching resistance to the absorber film 4 can be increased.

The second layer 34 can be a composition-gradient film having a gradient composition. In the second layer 34, the content of the metal element Ea can be larger than the content of the metal element Em on a side in contact with the first layer 32, and the content of the metal element Em can be larger than the content of the metal element Ea on a side in contact with the absorber film 4. In addition, in the second layer 34, the content of the metal element Ea can be increased, and the content of the metal element Em can be decreased from the absorber film 4 side toward the first layer 32 side in a film thickness direction thereof.

In the second layer 34 in the present specification, the "thin film formed under a condition in which the thin film contains the metal element Em" or the "thin film formed under a condition in which the thin film contains the metal element Ea" means a thin film formed under a condition in which a thin film containing the metal element Em is formed or a thin film formed under a condition in which a thin film containing the metal element Ea is formed at the time of forming the first layer 32. After formation of the second layer 34, an element other than an element constituting the second layer 34 may diffuse from the first layer 32 into the second layer 34. In this case, for example, the "thin film formed under a condition in which the thin film contains the metal element Em" contains an element (for example, silicon (Si)) diffusing from the first layer 32 into the second layer 34 after the formation of the first layer 32. As described above, elements of other thin films diffuse from thin films in the vicinity of the second layer 34 into the second layer 34, whereby a thin film formed under a condition in which the thin film contains a predetermined element generally contains elements other than the predetermined element.

The second layer 34 preferably contains one or more elements selected from ruthenium (Ru), rhodium (Rh), and iridium (Ir) as the metal element Em. By using these elements, it is possible to obtain the second layer 34 having high etching resistance and high heat resistance while maintaining a high reflectance.

The content of the metal element Em in the second layer 34 is preferably 40 to 95 at%, and more preferably 50 to 90 at%. The content of the metal element Ea in the second layer 34 is preferably 1 to 10 at%, and more preferably 2 to 8 at%. Note that the above-described content is a content at a position where the total content (at%) of the Em element and the Ea element is a maximum value, and can also be said to be the composition of a center of the second layer 34 in the film thickness direction.

The second layer 34 can further contain at least one selected from nitrogen (N) and oxygen (O). The second layer 34 can be a thin film formed under a condition in which the thin film contains the metal element Em, the metal element Ea, and at least one selected from nitrogen (N) and oxygen (O). The second layer 34 can be a thin film formed under a condition in which the thin film contains the metal element Em, the metal element Ea, and only at least one selected from nitrogen (N), and oxygen (O).

In order for the second layer 34 to have a high reflectance for EUV light, the content of nitrogen (N) and/or oxygen (O) in the second layer 34 is preferably low. Meanwhile, when the content of nitrogen (N) and/or oxygen (O) is high, it is possible to suppress diffusion of an element (for example, silicon (Si)) of the first layer 32 into the second layer 34. By suppressing diffusion of an element (for example, silicon (Si)) of the first layer 32 into the second layer 34, it is possible to suppress a decrease in effective film thickness of the second layer 34 having a function as the protective film 3. In consideration of the above, the second layer 34 preferably contains nitrogen (N) and/or oxygen (O) in the vicinity of an interface with the first layer 32. This makes it possible to suppress a decrease in reflectance of the multilayer reflective film 2 for EUV light due to diffusion of an element of the first layer 32 into the second layer 34.

The total film thickness of the first layer 32 and the second layer 34 of the protective film 3 (also simply referred to as "film thickness of the protective film 3") is not particularly limited as long as it can function as the protective film 3. The film thickness of the protective film 3 can be 3.5 nm or more, and can be 6.0 nm or more from a viewpoint of a reflectance for EUV light. The film thickness of the protective film 3 can be 8.0 nm or less, and can be 7.0 nm or less.

The second layer 34 of the protective film 3 of the present embodiment can be formed by various known methods, for example, an ion beam sputtering method, a sputtering method, a reactive sputtering method, a vapor phase growth method (CVD), and a vacuum vapor deposition method. The second layer 34 of the protective film 3 of the present embodiment is preferably formed by a magnetron sputtering method (reactive sputtering method) in a nitrogen gas atmosphere. As a target, for example, a single metal target or an alloy target of a metal component (a metal element, for example the metal element Em and/or the metal element Ea) contained in the second layer 34 can be used. When the second layer 34 is formed by a reactive sputtering method, the second layer 34 can be continuously formed in a nitrogen gas atmosphere after formation of the first layer 32.

When the second layer 34 is a thin film formed under a condition in which the thin film contains the metal element Em, the metal element Ea, and nitrogen (N) and/or oxygen (O), the second layer 34 can be formed by, for example, a DC magnetron sputtering method (reactive sputtering method) using an alloy target of at least one metal element Em and at least one metal element Ea in a nitrogen (N) gas and/or oxygen (O) gas atmosphere.

By changing film forming conditions such as a flow rate (pressure) of a nitrogen gas and/or applied power when the second layer 34 is formed, the second layer 34 having a predetermined composition distribution can be formed. Note that when appropriate film forming conditions are selected, even if a film is formed while the film forming conditions are kept constant, the second layer 34 having a predetermined composition distribution can be formed by diffusion of elements in the second layer 34. For example, in a case of obtaining the second layer 34 containing silicon (Si), even if the second layer 34 is formed under a condition in which the second layer 34 contains no silicon (Si), the second layer 34 containing silicon (Si) can be obtained by diffusion of silicon (Si) from the first layer 32 after the film formation.

### <<<Si2P spectrum analysis in protective film 3>>

As described above, when the protective film 3 has a structure in which the first layer (for example, a Si thin film) 32 on the multilayer reflective film 2 and the second layer 34 containing a metal material on the first layer 32 are disposed, Si in the protective film 3 mutually diffuses due to a heat treatment in a process of manufacturing the reflective mask 200, and a phenomenon may occur in which a reflectance of the protective film 3 for EUV light decreases. In particular, a metal oxide film resist that has been studied for high NA exposure in recent years requires higher heat resistance because the metal oxide film resist needs to be baked at a higher temperature than a currently used temperature, and an output of an exposure light source has been increased.

It can be said that the mutual diffusion of Si when a thermal load is applied depends on a chemical bonding state (chemical shift) between Si and another component (for example, O, N, C, or a combination of these elements) at an interface between the first layer 32 and the second layer 34. Therefore, the present inventor defined a P value calculated based on a Si2p spectrum analyzed by X-ray photoelectron spectroscopy (XPS) as an index of thermal diffusion suppression by the following formula 1. [Mathematical Formula 1] $P = \frac{{S}_{SiX} \left({u}_{SiX}-{u}_{Si}\right)}{{S}_{Si}}$
SiX: Si (silicon) compound
S_{Si}: area of peak derived from Si in Si2p spectrum
S_{SiX}: area of peak derived from SiX in Si2p spectrum
u_{Si}: position of peak derived from Si
u_{SiX}: position of peak derived from SiX

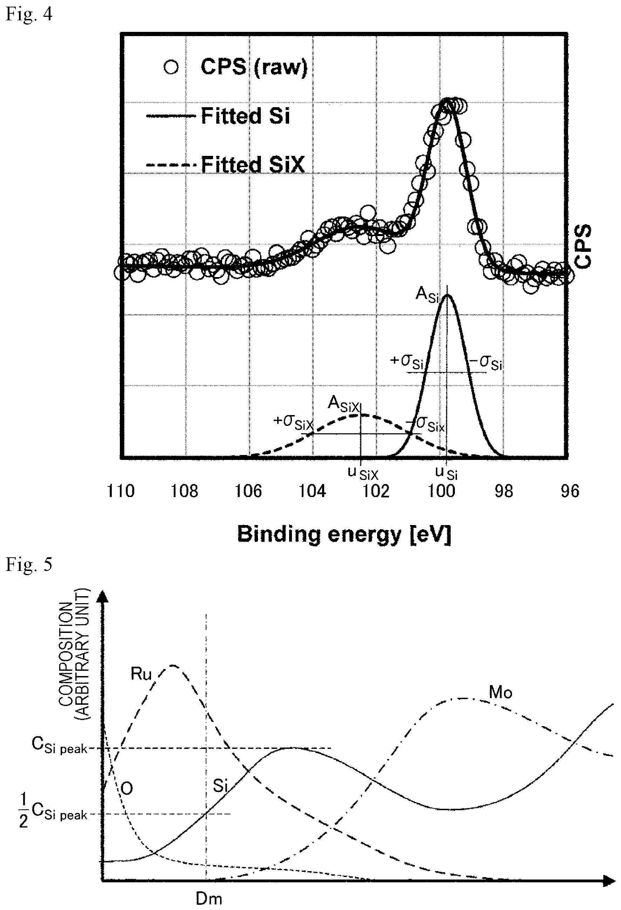

As in the above formula, the P value is obtained by multiplying an area ratio (S_{SiX}/S_{Si}) of a SiX-derived peak to a Si-derived peak analyzed in a Si2p spectrum by a peak shift amount (u_{SiX} - u_{Si}). A method for calculating the P value will be specifically described with reference to Fig. 4. Fig. 4 is an example of a Si2p spectrum measured in the vicinity of an interface between the first layer 32 and the second layer 34 of the protective layer 3 containing Si.

In the Si2p spectrum illustrated in Fig. 4, a peak derived from Si (silicon) and a peak derived from SiX (silicon compound) are observed. Assuming that each peak follows a Gaussian distribution, a fitting curve of the following formula 2 can be obtained based on the measured Si2p spectrum. [Mathematical Formula 2] $Fitting = {Σ}^{k = Si , SiX} {A}_{k} exp \left\{-\frac{{\left(x-{u}_{k}\right)}^{2}}{2 {σ}_{k}^{2}}\right\} + Background$

When an actually measured value (CPS) obtained by X-ray photoelectron spectroscopy is fitted to a Gaussian function, a known regression method such as a least squares method can be used.

An area S_{Si} of a peak derived from Si and an area S_{SiX} of a peak derived from SiX in the Si2p spectrum can be calculated from the following formula 3 using a coefficient of the Gaussian function to which the actually measured value is fitted. [Mathematical Formula 3] ${S}_{k} = {\int }_{- ∞}^{+ ∞} {A}_{k} exp \left\{-\frac{{\left(x-{u}_{k}\right)}^{2}}{2 {σ}_{k}^{2}}\right\} = \sqrt{2 π} {A}_{k} {σ}_{k}$

In the present embodiment, in order to measure a Si2p spectrum in the vicinity of an interface between the first layer 32 and the second layer 34 of the protective film 3, a measurement depth with respect to the protective film 3 is determined based on depth direction analysis illustrated in Fig. 5. Specifically, in a composition profile of a composition amount (or a composition ratio) in the depth direction as exemplified in Fig. 5, a depth at which the Si amount indicates 1/2 of a first peak value (C_{Si peak}) of the protective film 3 in the depth direction can be determined as a measurement depth (Dₘ).

The P value calculated as described above is preferably 1.5 or more, more preferably 2.0 or more, and still more preferably 3.0 or more. In addition, the P value is preferably 10.0 or less, more preferably 7.0 or less, and still more preferably 4.0 or less. A reason for this is that when the P value is too high, a ratio of SiX (silicon compound) in the protective film 3 is large, and a reflectance for EUV light is low.

In the protective film 3 of the present embodiment, the P value calculated based on the Si2p spectrum is set within the predetermined range, whereby it is possible to obtain the substrate 90 with a multilayer reflective film having higher heat resistance than a conventional one without causing a decrease in reflectance for EUV light even under a high temperature heat treatment.

In the measurement by the XPS method, the composition profile of the protective film 3 in the depth direction may be acquired by performing measurement from a state of a reflective mask blank including the absorber film 4 or including the absorber film 4 and the etching mask film 6 on the protective film 3, or a state of a reflective mask after the absorber film 4 is patterned. Also in this case, the P value can be calculated without being affected by a thin film on the protective film 3.

In addition, the P value can be set within a predetermined range by a film forming treatment of the first layer 32 and/or the second layer 34 by a reactive sputtering method in a gas atmosphere containing O, N, and/or C, an oxidation treatment and/or a nitriding treatment of a surface of the first layer 32, an annealing treatment of the first layer 32 and/or the second layer 34, conditions of the annealing treatment (an atmosphere such as vacuum, air, a nitrogen gas, or an oxygen gas, and a temperature), or a combination of these treatments.

In the substrate 90 with a multilayer reflective film of the present embodiment, after the protective film 3 is formed or after the absorber film 4 is formed to obtain the reflective mask blank 100, a heat treatment can be performed for stress adjustment of a thin film such as the protective film 3. In this heat treatment, heating can be performed at a temperature higher than a prebaking temperature (about 110°C) of the resist film 11 in a process of manufacturing the reflective mask blank 100.
Specifically, the temperature condition of the heat treatment can be 150°C or higher, and can be 220°C or higher. The temperature condition of the heat treatment can be 300°C or lower, and can be 270°C or lower.

### <<Conductive back film 5>>

The substrate 90 with a multilayer reflective film of the present embodiment can include the conductive back film 5 for an electrostatic chuck. The conductive back film 5 can be formed on the second main surface (back main surface) of the substrate 1 (on a surface opposite to a surface on which the multilayer reflective film 2 is formed or on an intermediate layer such as a hydrogen intrusion suppressing film when the intermediate layer is formed on the substrate 1). Sheet resistance required for the conductive back film 5 for an electrostatic chuck is usually 100 Ω/□ (Ω/square) or less. A method for forming the conductive back film 5 is, for example, a magnetron sputtering method or an ion beam sputtering method using a target of a metal such as chromium or tantalum or an alloy thereof. A material containing chromium (Cr) for the conductive back film 5 is preferably a Cr compound containing Cr and at least one selected from boron, nitrogen, oxygen, and carbon. Examples of the Cr compound include CrN, CrON, CrCN, CrCON, CrBN, CrBON, CrBCN, CrBOCN, and the like. As a material containing tantalum (Ta) for the conductive back film 5, it is preferable to use Ta (tantalum), an alloy containing Ta, or a Ta compound containing either Ta or an alloy containing Ta and at least one selected from boron, nitrogen, oxygen, and carbon. Examples of the Ta compound include TaB, TaN, TaO, TaON, TaCON, TaBN, TaBO, TaBON, TaBCON, TaHf, TaHfO, TaHfN, TaHfON, TaHfCON, TaSi, TaSiO, TaSiN, TaSiON, TaSiCON, and the like. The film thickness of the conductive back film 5 is not particularly limited as long as a function of the conductive back film 5 for an electrostatic chuck is satisfied, but is usually 10 nm to 200 nm. The conductive back film 5 also adjusts a stress on the second main surface side of the mask blank 100. That is, the conductive back film 5 is adjusted such that the flat reflective mask blank 100 can be obtained in balance with a stress from various films formed on the first main surface side.

Note that the substrate 90 with a multilayer reflective film does not necessarily include the conductive back film 5. For example, the conductive back film 5 can be formed on the reflective mask blank 100 after the absorber film 4 described later is formed.

### <Reflective mask blank 100>

The reflective mask blank 100 of the present embodiment will be described. As illustrated in Fig. 2, the reflective mask blank 100 of the present embodiment includes the absorber film 4 on the protective film 3 of the substrate 90 with a multilayer reflective film described above.

### <<Absorber film 4>>

The absorber film 4 of the reflective mask blank 100 of the present embodiment is formed on the protective film 3. A basic function of the absorber film 4 is to absorb EUV light. The absorber film 4 may be the absorber film 4 for the purpose of absorbing EUV light, or may be the absorber film 4 having a phase shift function in consideration of a phase difference of EUV light. The absorber film 4 having a phase shift function absorbs EUV light and reflects a part of the EUV light to shift a phase. That is, in the reflective mask 200 in which the absorber film 4 having a phase shift function is patterned, in a portion where the absorber film 4 is formed, a part of light is reflected at a level that does not adversely affect pattern transfer while EUV light is absorbed and attenuated. In addition, in a region (field portion) where the absorber film 4 is not formed, EUV light is reflected from the multilayer reflective film 2 via the protective film 3. Therefore, there is a desired phase difference between reflected light from the absorber film 4 having a phase shift function and reflected light from the field portion. The absorber film 4 having a phase shift function is formed such that a phase difference between reflected light from the absorber film 4 and reflected light from the multilayer reflective film 2 is 170 to 260 degrees. Light beams having a reversed phase difference interfere with each other at a pattern edge portion, and an image contrast of a projected optical image is thereby improved. As the image contrast is improved, resolution is increased, and various exposure-related margins such as an exposure margin and a focus margin can be increased.

The absorber film 4 may be a single-layer film or a multilayer film including a plurality of films (for example, a lower absorber film (buffer layer) and an upper absorber film). In a case of a single-layer film, the number of steps at the time of manufacturing a mask blank can be reduced and production efficiency is increased. In a case of a multilayer film, an optical constant and a film thickness of an upper absorber film can be appropriately set such that the upper absorber film serves as an antireflection film at the time of mask pattern defect inspection using light. This improves inspection sensitivity at the time of mask pattern defect inspection using light. In addition, when a film containing oxygen (O), nitrogen (N), and the like that improve oxidation resistance is used as the upper absorber film, temporal stability is improved. As described above, by forming the absorber film 4 into a multilayer film, various functions can be added to the absorber film 4. When the absorber film 4 is the absorber film 4 having a phase shift function, by forming the absorber film 4 into a multilayer film, a range of optical adjustment can be increased, and therefore a desired reflectance can be easily obtained.

A material of the absorber film 4 is not particularly limited as long as the material has a function of absorbing EUV light, can be processed by etching or the like (preferably, can be etched by dry etching with a chlorine (Cl)-based gas and/or a fluorine (F)-based gas), and has a high etching selective ratio to the protective film 3 (second layer 34). As a material having such a function, at least one metal selected from palladium (Pd), silver (Ag), platinum (Pt), gold (Au), iridium (Ir), tungsten (W), chromium (Cr), cobalt (Co), manganese (Mn), tin (Sn), tantalum (Ta), vanadium (V), nickel (Ni), hafnium (Hf), iron (Fe), copper (Cu), tellurium (Te), zinc (Zn), magnesium (Mg), germanium (Ge), aluminum (Al), rhodium (Rh), ruthenium (Ru), molybdenum (Mo), niobium (Nb), titanium (Ti), zirconium (Zr), yttrium (Y), and silicon (Si), an alloy containing two or more metals selected therefrom, or a compound thereof can be preferably used. The compound may contain the above metal or alloy and oxygen (O), nitrogen (N), carbon (C), and/or boron (B).

The absorber film 4 can be formed by a magnetron sputtering method such as a DC sputtering method or an RF sputtering method. For example, the absorber film 4 such as a tantalum compound can be formed by a reactive sputtering method using a target containing, for example, tantalum and boron and using an argon gas containing oxygen or nitrogen.

In addition, a crystalline state of the absorber film 4 is preferably an amorphous or microcrystalline structure from a viewpoint of smoothness and flatness. When the surface of the absorber film 4 is not smooth or flat, the absorber pattern 4a may have a large edge roughness and a poor pattern dimensional accuracy. The absorber film 4 has a surface roughness of preferably 0.5 nm or less, more preferably 0.4 nm or less, still more preferably 0.3 nm or less in terms of root mean square roughness (Rms).

In the present embodiment, it is possible to obtain the reflective mask blank 100 capable of suppressing a decrease in reflectance of the multilayer reflective film 2 for EUV light even when the reflective mask blank 100 having a structure in which the protective film 3 made of a material containing a metal is disposed on a high refractive index layer is subjected to a heat treatment.

### <<Etching mask film 6>>

As illustrated in Fig. 3, the reflective mask blank 100 of the present embodiment can include the etching mask film 6 on the absorber film 4. As a material of the etching mask film 6, a material having a high etching selective ratio of the absorber film 4 to the etching mask film 6 (etching rate of absorber film 4/etching rate of etching mask film 6) is preferably used. The etching selective ratio of the absorber film 4 to the etching mask film 6 is preferably 1.5 or more, and more preferably 3 or more.

The reflective mask blank 100 of the present embodiment preferably includes the etching mask film 6 on the absorber film 4.

As a material of the etching mask film 6, chromium or a chromium compound is preferably used. Examples of the chromium compound include a material containing Cr and at least one element selected from N, O, C, and H. The etching mask film 6 more preferably contains CrN, CrO, CrC, CrON, CrOC, CrCN, or CrOCN, and is still more preferably a CrO-based film containing chromium and oxygen (CrO film, CrON film, CrOC film, or CrOCN film).

As the material of the etching mask film 6, tantalum or a tantalum compound is preferably used. Examples of the tantalum compound include a material containing Ta and at least one element selected from N, O, B, and H. The etching mask film 6 more preferably contains TaN, TaO, TaON, TaBN, TaBO, or TaBON.

As the material of the etching mask film 6, silicon or a silicon compound is preferably used. Examples of the silicon compound include a material containing Si and at least one element selected from N, O, C, and H, a metallic silicon containing a metal in silicon or a silicon compound (metal silicide), a metal silicon compound (metal silicide compound), and the like. Examples of the metal silicon compound include a material containing a metal, Si, and at least one element selected from N, O, C, and H.

The film thickness of the etching mask film 6 is preferably 3 nm or more in order to accurately form a pattern on the absorber film 4. In addition, the film thickness of the etching mask film 6 is preferably 15 nm or less in order to reduce the film thickness of the resist film 11.

### <Reflective mask 200>

The present embodiment is the reflective mask 200 including the absorber pattern 4a obtained by patterning the absorber film 4 of the above-described reflective mask blank.

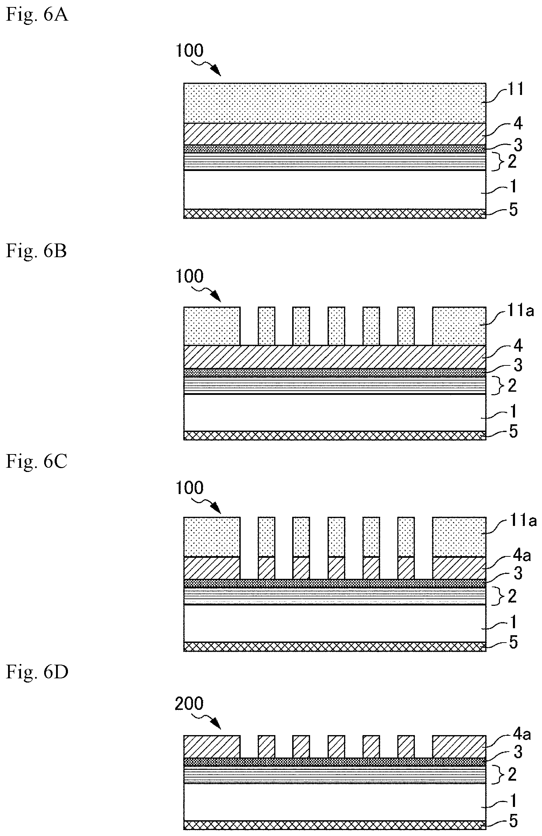

As illustrated in Fig. 6D, the reflective mask 200 of the present embodiment has the absorber pattern 4a obtained by patterning the absorber film 4 of the above-described reflective mask blank 100.

Figs. 6A to 6D are schematic views illustrating an example of a method for manufacturing the reflective mask 200. Using the above-described reflective mask blank 100 of the present embodiment, the reflective mask 200 of the present embodiment can be manufactured. Hereinafter, an example of the method for manufacturing the reflective mask 200 will be described.

First, the reflective mask blank 100 including the substrate 1, the multilayer reflective film 2 formed on the substrate 1, the protective film 3 formed on the multilayer reflective film 2, and the absorber film 4 formed on the protective film 3 is prepared. Next, the resist film 11 is formed on the absorber film 4 to obtain the reflective mask blank 100 with the resist film 11 (Fig. 6A). A pattern is drawn on the resist film 11 with an electron beam drawing device, and then the resulting product is subjected to a development and rinse step to form a resist pattern 11a (Fig. 6B).

The absorber film 4 is dry-etched using the resist pattern 11a as a mask. As a result, a portion not covered with the resist pattern 11a in the absorber film 4 is etched to form the absorber pattern 4a (Fig. 6C).

As an etching gas for the absorber film 4, for example, a fluorine-based gas and/or a chlorine-based gas can be used. As the fluorine-based gas, CF₄, CHF₃, C₂F₆, C₃F₆, C₄F₆, C₄F₈, CH₂F₂, CH₃F, C₃F₈, SF₆, F₂, and the like can be used. As the chlorine-based gas, Cl₂, SiCl₄, CHCl₃, CCl₄, BCl₃, and the like can be used. In addition, a mixed gas containing a fluorine-based gas and/or a chlorine-based gas and O₂ at a predetermined ratio can be used. These etching gases can each further contain an inert gas such as He and/or Ar as necessary.

After the absorber pattern 4a is formed, the resist pattern 11a is removed with a resist peeling liquid. After the resist pattern 11a is removed, the resulting product is subjected to a wet cleaning step using an acidic or alkaline aqueous solution to obtain the reflective mask 200 of the present embodiment (Fig. 6D).

Note that, when the reflective mask blank 100 in which the etching mask film 6 is formed on the absorber film 4 is used, a step of forming a pattern (etching mask pattern) on the etching mask film 6 using the resist pattern 11a as a mask and then forming a pattern on the absorber film 4 using the etching mask pattern as a mask is added.

The reflective mask 200 thus obtained has a structure in which the multilayer reflective film 2, the protective film 3, and the absorber pattern 4a are layered on the substrate 1.

A region (reflection region) where the multilayer reflective film 2 covered with the protective film 3 is exposed has a function of reflecting EUV light. A region where the multilayer reflective film 2 and the protective film 3 are covered with the absorber pattern 4a has a function of absorbing EUV light. The reflective mask 200 of the present embodiment can suppress a decrease in reflectance of a reflection region for EUV light even when the reflective mask 200 is subjected to a heat treatment. By using the reflective mask 200 of the present embodiment, it is possible to obtain a reflection region that maintains a high reflectance for EUV light, and therefore a finer pattern can be transferred onto a transferred object in EUV lithography.

In the reflective mask 200 of the present embodiment, adhesion of an interface between the first layer 32 and the second layer 34 of the protective film 3 can be improved. Therefore, occurrence of a film peeling defect of the reflective mask 200 of the present embodiment can be suppressed. In addition, in the reflective mask 200 of the present embodiment, adhesion of an interface between the first layer 32 and the second layer 34 of the protective film 3 can be improved, a high reflectance for EUV light can be maintained, and high heat resistance of the protective film 3 can be obtained. Therefore, the reflective mask 200 of the present embodiment can be used for manufacturing a high-performance semiconductor device.

### <Method for manufacturing a semiconductor device>

A method for manufacturing a semiconductor device of the present embodiment includes a step of performing a lithography process using an exposure apparatus using the above-described reflective mask 200 to form a transfer pattern on a transferred object.

A transfer pattern can be formed on a semiconductor substrate 60 (transferred object) by lithography using the reflective mask 200 of the present embodiment. This transfer pattern has a shape obtained by transferring a pattern of the reflective mask 200. By forming a transfer pattern on the semiconductor substrate 60 with the reflective mask 200, a semiconductor device can be manufactured.

According to the present embodiment, a semiconductor device can be manufactured using the reflective mask 200 including, as raw materials, the substrate 90 with a multilayer reflective film and the reflective mask blank 100 capable of suppressing a decrease in reflectance of the multilayer reflective film 2 for EUV light even when the substrate 90 with a multilayer reflective film and the reflective mask blank 100 are subjected to a heat treatment. Therefore, by using the reflective mask 200 of the present embodiment, it is possible to increase density and accuracy of a semiconductor device.

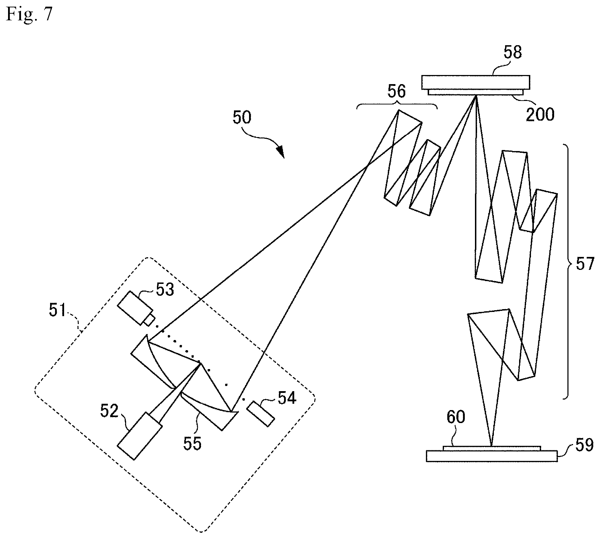

A method for transferring a pattern onto the semiconductor substrate 60 with resist using EUV light will be described with reference to Fig. 7.

Fig. 7 illustrates a schematic configuration of an EUV exposure apparatus 50 that is an apparatus for transferring a transfer pattern onto the resist film 11 formed on the semiconductor substrate 60. In the EUV exposure apparatus 50, an EUV light generation unit 51, an irradiation optical system 56, a reticle stage 58, a projection optical system 57, and a wafer stage 59 are precisely arranged along an optical path axis of EUV light. A container of the EUV exposure apparatus 50 is filled with a hydrogen gas.

The EUV light generation unit 51 includes a laser light source 52, a tin droplet generation unit 53, a catching unit 54, and a collector 55. When a tin droplet emitted from the tin droplet generation unit 53 is irradiated with a high-power carbon dioxide laser from the laser light source 52, tin in a droplet state is turned into plasma to generate EUV light. The generated EUV light is collected by the collector 55, passes through the irradiation optical system 56, and enters the reflective mask 200 set on the reticle stage 58. The EUV light generation unit 51 generates, for example, EUV light having a wavelength of 13.53 nm.

EUV light reflected by the reflective mask 200 is usually reduced to about 1/4 of pattern image light by the projection optical system 57 and projected on the semiconductor substrate 60 (transferred substrate). As a result, a given circuit pattern is transferred onto the resist film on the semiconductor substrate 60. The resist film that has been subjected to exposure is developed, whereby a resist pattern can be formed on the semiconductor substrate 60. By etching the semiconductor substrate 60 using the resist pattern as a mask, an integrated circuit pattern can be formed on the semiconductor substrate 60. Through such steps and other necessary steps, a semiconductor device is manufactured.

### Working Examples

Hereinafter, examples 1 to 11 will be described. Examples 1 to 4 and 8 to 11 are Working Examples, and examples 5 to 7 are Comparative Examples. These examples do not limit the present invention.

As examples 1 to 11, the substrates 90 with a multilayer reflective film in each of which the multilayer reflective film 2 and the protective film 3 were formed on a first main surface of the substrate 1 were prepared.

The substrates 90 with a multilayer reflective film in examples 1 to 11 were prepared as follows.

A SiO₂-TiO₂-based glass substrate 1 that is a low thermal expansion glass substrate 1 having a 6025 size (approximately 152 mm × 152 mm × 6.35 mm) and having polished both main surfaces that are a first main surface and a second main surface was prepared as the substrate 1. The main surfaces were subjected to polishing including a rough polishing step, a precision polishing step, a local processing step, and a touch polishing step such that the main surfaces were flat and smooth.

Next, the multilayer reflective film 2 was formed on the first main surface of the substrate 1. The multilayer reflective film 2 was the periodic multilayer reflective film 2 containing Si and Mo in order to make the multilayer reflective film 2 suitable for EUV light having a wavelength of 13.5 nm. Specifically, a Si target and a Mo target were used as a target of a high refractive index material and a target of a low refractive index material, respectively. Krypton (Kr) ion particles were supplied from an ion source to these targets, and ion beam sputtering was performed to alternately build up a Si layer and a Mo layer on the substrate 1.

Here, sputtered particles of Si and Mo were made incident at an angle of 30 degrees with respect to a normal line of the first main surface of the substrate 1. First, a Si layer was formed so as to have a film thickness of 4.2 nm, and then a Mo layer was formed so as to have a film thickness of 2.8 nm. This stack was counted as one period, and the Si layer and the Mo layer were built up for 40 periods in a similar manner. Therefore, a material of the lowermost layer of the multilayer reflective film 2, that is, a material of the multilayer reflective film 2 closest to the substrate 1 is Si, and a material of the uppermost layer of the multilayer reflective film 2 is Mo.

Next, the protective film 3 including the first layer 32 and the second layer 34 was formed on each of the multilayer reflective films 2 in examples 1 to 11.

First, the first layer 32 of the protective film 3 was formed on a surface of the multilayer reflective film 2. The first layer 32 was formed under the same conditions as in the above-described method for forming the Si layer of the multilayer reflective film 2. At this time, the first layer 32 was formed such that the set thickness of the first layer 32 was 4.0 nm from a relationship between a film forming rate of a Si layer and a film forming time thereof under a predetermined condition.

In examples 1 to 3 and 11, after the formation of the first layer 32, an annealing treatment was performed while plasma irradiation was performed in a N₂ gas-containing atmosphere. In examples 4 and 10, after the formation of the first layer 32, plasma irradiation was performed in an Ar gas-containing atmosphere to remove an oxide layer formed on a surface of the first layer 32, and an annealing treatment was performed while plasma irradiation was performed in a N₂ gas-containing atmosphere. In examples 5 and 6, an annealing treatment was performed while plasma irradiation was performed in a mixed gas atmosphere of a N₂ gas and an Ar gas. In example 7, an annealing treatment was performed in air. In examples 8 and 9, after the formation of the first layer 32, an annealing treatment was performed while plasma irradiation was performed in an O₂ gas-containing atmosphere. Table 1 presents temperature and time of annealing.

Next, the second layer 34 was formed on a surface of the first layer 32. Table 2 presents continuity of a film forming process between the formation of the first layer 32 and the formation of the second layer 34. In a case described as "continuous" in Table 2, after the formation of the first layer 32, a sample was not taken out to air, and the second layer 34 was continuously formed in a film forming apparatus. In a case described as "discontinuous" in Table 2, after the formation of the first layer 32, a sample was taken out to air, then the sample was placed in a film forming apparatus, and the second layer 34 was formed.

Each of the second layers 34 in examples 1 to 4 and 6 to 11 was formed so as to have a set film thickness presented in Table 2 using a sintering target having a composition presented in Table 2 by a DC magnetron sputtering method (reactive sputtering method) in a gas atmosphere introduced at a flow rate ratio N₂/Ar of a N₂ gas and/or an Ar gas (flow rate unit sccm: Standard Cubic Centimeter per Minute) presented in Table 2. Note that the second layer 34 in example 4 was a two-layer film in which a lower layer was a Cr film and an upper layer was a Rh film. The second layer 34 in example 10 was a two-layer film in which a lower layer was a Zr film and an upper layer was a RhZr film. The RhZr film as the upper layer was formed using a Rh target and a Zr target. In the second layer 34 in example 10, the Zr content increased from the absorber film 4 side toward the first layer 32 side in a film thickness direction thereof. The second layer 34 in example 11 was a two-layer film in which a lower layer was a Ti film and an upper layer was a Rh film. In addition, the second layer 34 in example 5 was formed so as to have a set film thickness presented in Table 2 by supplying argon (Ar) ion particles from an ion source and performing ion beam sputtering using a Ru target. In examples 4, 7, 10, and 11, after formation of the second layer 34, an annealing treatment was performed under conditions presented in Table 2.

### (Measurement of P value)

Next, each of the protective films 3 (the first layer 32 and the second layer 34) in examples 1 to 11 was measured by X-ray photoelectron spectroscopy (XPS). In this measurement, by repeating a step of irradiating a surface of the protective film 3 with an X-ray (AlKα ray: 1486 eV) to measure an intensity of photoelectrons emitted from the protective film 3, digging the surface of the protective film 3 for a predetermined time (depth of about 0.7 nm) by Ar gas sputtering, and irradiating the protective film 3 in the dug region with an X-ray to measure an intensity of photoelectrons emitted from the protective film 3 in the dug region, a composition profile in the depth direction of each of the protective films 3 in examples 1 to 11 was obtained.

Next, in the composition profile in the depth direction of each of the protective films 3 in examples 1 to 11, a Si2p spectrum at a depth Dₘ at which the Si amount indicates 1/2 of a first peak value C_{Si peak} of the protective film 3 in the depth direction was extracted. The extracted Si2p spectrum was subjected to the above-described fitting using a Gaussian function. The P value was calculated from parameters obtained by fitting based on the above formula 1. Results thereof are presented in Table 3.

In addition, in the composition profile in the depth direction of each of the protective films 3 in examples 1 to 11, ratios (N/Si and O/Si) of the N content and the O content to the Si content at the depth Dₘ were calculated. Results thereof are presented in Table 3.

### (Evaluation of substrate 90 with a multilayer reflective film)

Using the substrates 90 with a multilayer reflective film in examples 1 to 11 prepared under film forming conditions similar to those described above, changes in reflectance due to a heat treatment to the substrates 90 with a multilayer reflective film were measured.

Specifically, first, a reflectance (R1, unit: %) of each of the substrates 90 with a multilayer reflective film in examples 1 to 11 for EUV light (wavelength: 13.5 nm) was measured. Next, the substrates 90 with a multilayer reflective film were subjected to a heat treatment by being heated at 250°C for 10 minutes in vacuum (1.0 × 10⁻⁴ Pa). After the substrates 90 with a multilayer reflective film were subjected to the heat treatment, a reflectance (R2, unit: %) of each of the substrates 90 with a multilayer reflective film for EUV light was measured. By subtracting a value of the reflectance (R2) of the substrate 90 with a multilayer reflective film after the heat treatment from a value of the reflectance (R1) of the substrate 90 with a multilayer reflective film before the heat treatment, a change in EUV reflectance of the substrate 90 with a multilayer reflective film due to the heat treatment was obtained. Note that, in example 7, since the reflectance (R1) before the heat treatment was low and a reflectance necessary for the substrate 90 with a multilayer reflective film could not be obtained, the heat treatment was not performed. Table 3 presents measurement results of changes (%) in reflectance of the substrates with a multilayer reflective films 90 in examples 1 to 6 and 8 to 11 for EUV light.

From the above, in each of the substrates 90 with a multilayer reflective film in examples 1 to 4 and 8 to 11, by setting the P value to 1.5 or more and 10.0 or less, a high reflectance for EUV light could be maintained after the heat treatment. Note that, in each of the substrates 90 with a multilayer reflective film in examples 8 and 9, although a change in reflectance was small, the reflectance (R1) before the heat treatment was lower than those in examples 1 to 4, 10, and 11. In addition, in each of the substrates 90 with a multilayer reflective film in examples 5 and 6, since the P value was less than 1.5, the reflectance for EUV light was reduced after the heat treatment.

**[Table 1]**

| | Annealing treatment | |
|---|---|---|
| | Atmosphere/Condition | Temperature/Time |
| Example 1 | N2 plasma irradiation | 200°C·10 min |
| Example 2 | N2 plasma irradiation | 200°C·10 min |
| Example 3 | N2 plasma irradiation | 200°C·10 min |
| Example 4 | Ar plasma irradiation→N2 plasma irradiation | 200°C·10 min |
| Example 5 | N2 + Ar plasma irradiation | 140°C·10 min |
| Example 6 | N2 + Ar plasma irradiation | 140°C·10 min |
| Example 7 | In air | 200°C·10 min |
| Example 8 | 02 plasma irradiation | 200°C·10 min |
| Example 9 | 02 plasma irradiation | 200°C·10 min |
| Example 10 | Ar plasma irradiation→N2 plasma irradiation | 200°C·10 min |
| Example 11 | N2 plasma irradiation | 200°C·10 min |

**[Table 2]**

| | Continuity with first layer | Film forming method | Flow rate ratio N2 (sccm)/Ar (sccm) | Em element | Ea element | Target composition ratio | Set film thickness | Annealing treatment |
|---|---|---|---|---|---|---|---|---|
| Example 1 | Continuous | PVD | 20/10 | RuRh | Cr | Ru:Rh:Cr = 60:30:10 | 3.5 nm | - |
| Example 2 | Continuous | PVD | 0/30 | Ru | Nb | Ru:Nb = 80:20 | 3.5 nm | - |
| Example 3 | Continuous | PVD | 0/30 | Ru | - | Ru = 100 | 3.5 nm | - |
| Example 4 | Discontinuous | PVD | Upper layer 0/30 | Rh | Cr | Rh = 100 | 2.5 nm | Vacuum annealing 200°C·10 min |
| | | | Lower layer 0/30 | | | Cr = 100 | 0.5 nm | |
| Example 5 | Continuous | IBD | - | Ru | - | Ru = 100 | 3.5 nm | - |
| Example 6 | Continuous | PVD | 0/30 | Ru | Nb | Ru:Nb = 80:20 | 3.5 nm | - |
| Example 7 | Discontinuous | PVD | 0/30 | Ru | Nb | Ru:Nb = 80:20 | 1.5 nm | Vacuum annealing 200°C·10 min |
| Example 8 | Continuous | PVD | 3/30 | Ru | Nb | Ru:Nb = 80:20 | 3.5 nm | - |
| Example 9 | Continuous | PVD | 20/10 | RuRh | Cr | Ru:Rh:Cr=60:30:10 | 3.5 nm | - |
| Example 10 | Discontinuous | PVD | Upper layer 0/30 | Rh | Zr | Rh = 100 | 2.0 nm | Vacuum annealing 200°C·10 min |
| | | | Lower layer 0/30 | | | Zr = 100 | 1.0 nm | |
| Example 11 | Discontinuous | PVD | Upper layer 0/30 | Rh | Ti | Rh = 100 | 2.0 nm | Vacuum annealing 200°C·10 min |
| | | | Lower layer 0/30 | | | Ti = 100 | 1.0 nm | |

**[Table 3]**

| | P value | N/Si | O/Si | Change in reflectance (%) |
|---|---|---|---|---|
| Example 1 | 3.91 | 0.68 | 0 | 0.2 |
| Example 2 | 1.77 | 0.2 | 0 | 0.3 |
| Example 3 | 1.58 | 0.18 | 0 | 0.3 |
| Example 4 | 3.5 | 0.58 | 0 | 0.2 |
| Example 5 | 0.58 | 0.07 | 0 | 1.1 |
| Example 6 | 0.52 | 0.08 | 0 | 1.2 |
| Example 7 | 11.5 | 0 | 2 | - |
| Example 8 | 5.5 | 0 | 0.9 | 0.3 |
| Example 9 | 9.3 | 0.68 | 0.9 | 0.2 |
| Example 10 | 3.2 | 0.58 | 0 | 0.2 |
| Example 11 | 1.53 | 0.2 | 0 | 0.3 |

### Reference Signs List

- 1: Substrate
- 2: Multilayer reflective film
- 3: Protective film
- 4: Absorber film
- 4a: Absorber pattern
- 5: Conductive back film
- 6: Etching mask film
- 11: Resist film
- 11a: Resist pattern
- 32: First layer
- 34: Second layer
- 50: EUV exposure apparatus
- 51: EUV light generation unit
- 52: Laser light source
- 53: Tin droplet generation unit
- 54: Catching unit
- 55: Collector
- 56: Irradiation optical system
- 57: Projection optical system
- 58: Reticle stage
- 59: Wafer stage
- 60: Semiconductor substrate
- 90: Substrate with a multilayer reflective film
- 100: Reflective mask blank
- 200: Reflective mask

## Claims

1. A substrate with a multilayer reflective film, comprising: a substrate; a multilayer reflective film disposed on the substrate; and a protective film disposed on the multilayer reflective film, wherein
the protective film comprises a first layer on the multilayer reflective film and a second layer in contact with the first layer,
the first layer and the second layer of the protective film comprise silicon (Si),
a P value of the protective film is 1.5 or more and 10.0 or less, and
the P value is calculated based on a Si2p spectrum analyzed by X-ray photoelectron spectroscopy, and is defined as:$P = \left({S}_{SiX}{/ S}_{Si}\right) \times \left({u}_{SiX} - {u}_{Si}\right) ,$ wherein
SiX: compound of Si;
S_{Si}: area of peak derived from Si in Si2p spectrum;
S_{SiX}: area of peak derived from SiX in Si2p spectrum;
u_{Si}: position of peak derived from Si; and
u_{SiX}: position of peak derived from SiX.

2. The substrate with a multilayer reflective film according to claim 1, wherein the first layer comprises silicon (Si) and one or more elements selected from oxygen (O) and nitrogen (N).

3. The substrate with a multilayer reflective film according to claim 2, wherein a ratio of a content of one or more elements selected from O and N to a content of Si in the first layer is 0.1 or more and 1.5 or less.

4. The substrate with a multilayer reflective film according to claim 1, wherein the second layer comprises one or more elements selected from ruthenium (Ru), rhodium (Rh), and iridium (Ir).

5. The substrate with a multilayer reflective film according to any one of claims 1 to 4, wherein the second layer comprises one or more elements selected from thallium (Tl), hafnium (Hf), titanium (Ti), zirconium (Zr), yttrium (Y), manganese (Mn), indium (In), gallium (Ga), cadmium (Cd), bismuth (Bi), tantalum (Ta), lead (Pb), silver (Ag), aluminum (Al), vanadium (V), niobium (Nb), tin (Sn), zinc (Zn), mercury (Hg), chromium (Cr), iron (Fe), antimony (Sb), tungsten (W), molybdenum (Mo), and copper (Cu).

6. A reflective mask blank comprising: a substrate; a multilayer reflective film disposed on the substrate; a protective film disposed on the multilayer reflective film; and an absorber film disposed on the protective film, wherein
the protective film comprises a first layer on the multilayer reflective film and a second layer in contact with the first layer,
the first layer and the second layer of the protective film comprise silicon (Si),
a P value of the protective film is 1.5 or more and 10.0 or less, and
the P value is calculated on a basis of a Si2p spectrum analyzed by X-ray photoelectron spectroscopy, and is defined as:$P = \left({S}_{SiX}{/ S}_{Si}\right) \times \left({u}_{SiX} - {u}_{Si}\right) ,$ wherein
SiX: compound of Si;
S_{Si}: area of peak derived from Si in Si2p spectrum;
Ssix: area of peak derived from SiX in Si2p spectrum;
u_{Si}: position of peak derived from Si; and
u_{SiX}: position of peak derived from SiX.

7. The reflective mask blank according to claim 6, wherein the first layer comprises silicon (Si) and one or more elements selected from oxygen (O) and nitrogen (N).

8. The reflective mask blank according to claim 7, wherein a ratio of a content of one or more elements selected from O and N to a content of Si in the first layer is 0.1 or more and 1.5 or less.

9. The reflective mask blank according to claim 6, wherein the second layer comprises one or more elements selected from ruthenium (Ru), rhodium (Rh), and iridium (Ir).

10. The reflective mask blank according to any one of claims 6 to 9, wherein the second layer comprises one or more elements selected from thallium (Tl), hafnium (Hf), titanium (Ti), zirconium (Zr), yttrium (Y), manganese (Mn), indium (In), gallium (Ga), cadmium (Cd), bismuth (Bi), tantalum (Ta), lead (Pb), silver (Ag), aluminum (Al), vanadium (V), niobium (Nb), tin (Sn), zinc (Zn), mercury (Hg), chromium (Cr), iron (Fe), antimony (Sb), tungsten (W), molybdenum (Mo), and copper (Cu).

11. A reflective mask comprising: a substrate; a multilayer reflective film disposed on the substrate; a protective film disposed on the multilayer reflective film; and an absorber pattern disposed on the protective film, wherein
the protective film comprises a first layer on the multilayer reflective film and a second layer in contact with the first layer,
the first layer and the second layer of the protective film comprise silicon (Si),
a P value of the protective film is 1.5 or more and 10.0 or less, and
the P value is calculated based on a Si2p spectrum analyzed by X-ray photoelectron spectroscopy, and is defined as:$P = \left({S}_{SiX}{/ S}_{Si}\right) \times \left({u}_{SiX} - {u}_{Si}\right) ,$ wherin
SiX: compound of Si;
S_{Si}: area of peak derived from Si in Si2p spectrum;
S_{SiX}: area of peak derived from SiX in Si2p spectrum;
u_{Si}: position of peak derived from Si; and
u_{SiX}: position of peak derived from SiX.

12. The reflective mask according to claim 11, wherein the first layer comprises silicon (Si) and one or more elements selected from oxygen (O) and nitrogen (N).

13. The reflective mask according to claim 12, wherein a ratio of a content of one or more elements selected from O and N to a content of Si in the first layer is 0.1 or more and 1.5 or less.

14. The reflective mask according to claim 11, wherein the second layer comprises one or more elements selected from ruthenium (Ru), rhodium (Rh), and iridium (Ir).

15. The reflective mask according to any one of claims 11 to 14, wherein the second layer comprises one or more elements selected from thallium (Tl), hafnium (Hf), titanium (Ti), zirconium (Zr), yttrium (Y), manganese (Mn), indium (In), gallium (Ga), cadmium (Cd), bismuth (Bi), tantalum (Ta), lead (Pb), silver (Ag), aluminum (Al), vanadium (V), niobium (Nb), tin (Sn), zinc (Zn), mercury (Hg), chromium (Cr), iron (Fe), antimony (Sb), tungsten (W), molybdenum (Mo), and copper (Cu).

16. A method for manufacturing a semiconductor device, comprising performing a lithography process with an exposure apparatus using the reflective mask according to any one of claims 11 to 15 to form a transfer pattern on a transferred object.
